# EUROPÄISCHE PATENTSCHRIFT

(11) **EP 2 425 920 B1**
(45) Veröffentlichungstag und Bekanntmachung des Hinweises auf die Patenterteilung: **09.03.2016**
(21) Anmeldenummer: 11006845.9
(22) Anmeldetag: 22.08.2011
(51) Int. Cl.: B23K 35/36, B23K 35/365, B23K 35/368, B23K 35/02, B23K 35/30

(54) **VERWENDUNG VON ALIPHATISCHEN KOHLENWASSERSTOFFEN UND PARAFFINEN ALS LÖSEMITTEL IN SILBERSINTERPASTEN**
USE OF ALIPHATIC HYDROCARBONS AND PARAFFINS AS SOLVENT IN SILVER SINTERING PASTES
UTILISATION D'HYDROCARBURES ET DE PARAFFINES ALIPHATIQUES COMME SOLVANTS DANS DES PÂTES DE FRITTAGE D'ARGENT

(30) Priorität: 03.09.2010 DE 102010044326
(43) Veröffentlichungstag der Anmeldung: 07.03.2012
(73) Patentinhaber: Heraeus Deutschland GmbH & Co. KG, 63450 Hanau (DE)
(72) Erfinder: Schäfer, Michael, 36093 Künzell (DE); Schmitt, Wolfgang, 63110 Rodgau (DE)
(74) Vertreter: Heraeus IP

(56) Entgegenhaltungen:
- EP-A1- 1 758 443
- WO-A1-2004/026526
- WO-A1-2011/026624
- WO-A2-2005/079353
- DE-A1-102009 040 076

## Beschreibung

Die vorliegende Erfindung stellt ein Verfahren zur Befestigung eines elektronischen Bauelements auf einem Substrat sowie eine Paste, die bei diesem Verfahren eingesetzt werden kann, zur Verfügung.

Im Bereich der Leistungselektronik stellt das Verbinden von Substraten mit Bauelementen, wie LEDs oder sehr dünnen Siliziumchips, die eine hohe Druck- und Temperaturempfindlichkeit aufweisen, eine besondere Herausforderung dar.

Aus diesem Grund werden Substrate mit solchen druck- und temperaturempfindlichen Bauelementen häufig durch Kleben verbunden. Geeignete Leitkleber enthalten üblicherweise Silberpartikel, duroplastische Polymere und Reaktivverdünner. Die Klebetechnik besitzt jedoch den Nachteil, dass damit Kontaktstellen zwischen Substrat und Bauelement geschaffen werden, die nur eine unzureichende Wärmeleitfähigkeit bzw. elektrische Leitfähigkeit aufweisen. Um dieses Problem zu lösen, wurde vorgeschlagen, Substrat und elektronisches Bauelement durch Sintern miteinander zu verbinden.

Herkömmliche Sinterverfahren benötigen jedoch entweder einen hohen Prozessdruck oder aber eine hohe Prozesstemperatur. Diese Bedingungen führen häufig zu Schädigungen der zu verbindenden Bauelemente, so dass herkömmliche Sinterverfahren für viele Anwendungen ausscheiden.

Die WO 2004/026526 offenbart ein Sinterverfahren zum Verbinden eines elektronsichen Bauelements mit einem Substrat, bei dem eine Paste zum Einsatz kommt, die metallische Nanopartikel und ein organisches Solvens enthält.

In der DE 10 2007 046 901 A1 wird eine Sintertechnik.vorgeschlagen, mit der es gelingt, sehr gut elektrisch leitende und wärmeleitende Verbindungsschichten für die Leistungselektronik aufzubauen. Bei diesem Sinterverfahren wird eine Metallpaste verwendet, die neben einem alkoholischen Lösungsmittel eine Silberverbindung enthält, die sich unter 300°C zu elementarem Silber zersetzt. Diese Metallpasten ermöglichen eine Verringerung des Prozessdrucks auf unter 3 bar und eine Verringerung der Prozesstemperatur auf unter 250°C. Diese Sintertechnik stellt einen großen Qualitätssprung bei der Verbindung von Substraten mit druck- und temperaturempfindlichen Bauelementen dar.

Allerdings wäre es für viele Anwendungen wünschenswert, wenn die Prozesstemperatur noch weiter gesenkt werden könnte, ohne dabei Beeinträchtigungen im Hinblick auf die Scherfestigkeit der entstehenden Kontaktstelle in Kauf nehmen zu müssen. Dies würde zu einer geringeren Belastung der zu verbindenden Bauelemente und damit zu einer weiteren Qualitätssteigerung von Bauteilen auf dem Gebiet der Leistungselektronik sorgen. Darüber hinaus könnten bei einer weiteren Senkung der Prozesstemperatur in erheblichem Maße Energiekosten eingespart werden.

Die aus dem Stand der Technik bekannten Verfahren zum Befestigen von elektronischen Bauelementen auf Substraten sind unter einem weiteren Aspekt verbesserungsfähig. So ist es zwar im Einzelfall möglich, eine Kontaktschicht zwischen einem elektronischen Bauelement und einem Substrat zu erzeugen, die eine hohe Scherfestigkeit aufweist. In der Serienproduktion tritt dabei allerdings regelmäßig das Problem auf, dass diese Scherfestigkeit von Kontaktschicht zu Kontaktschicht stark variiert. Bislang war es daher nicht möglich, Kontaktschichten zwischen elektronischen Bauelementen und Substraten mit gleichbleibender Güte im Hinblick auf die Scherfestigkeit der Kontaktstellen zu erzeugen.

Der vorliegenden Erfindung liegt daher die Aufgabe zugrunde, ein Sinterverfahren bereitzustellen, das es erlaubt, ein elektronisches Bauelement mit einem Substrat auf stabile Weise zu verbinden, wobei die Prozesstemperatur bei unter 250°C liegt. Dabei sollen vorzugsweise mit gleichbleibender Güte Kontaktstellen zwischen dem Substrat und dem zu verbindenden Bauelement geschaffen werden, die eine hohe Scherfestigkeit, eine niedrige Porosität und eine hohe elektrische und thermische Leitfähigkeit aufweisen.

Eine weitere Aufgabe der vorliegenden Erfindung besteht darin, eine Paste bereitzustellen, die in dem erfindungsgemäßen Sinterverfahren verwendet werden kann.
Diese Aufgaben werden gelöst durch die Gegenstände der unabhängigen Ansprüche.

Gattungsgemäß stellt die Erfindung demnach ein Verfahren zum Befestigen eines elektronischen Bauelements mit einem Substrat bereit, bei dem man
(i) ein elektronisches Bauelement und ein Substrat bereitstellt,
(ii) eine Sandwichanordnung schafft, die das elektronische Bauelement, das Substrat und eine dazwischen angeordnete Schicht aufweist, die eine Paste umfasst, die (a) Metallpartikel, die ein Coating aufweisen, das wenigstens eine Verbindung umfasst, die aus der Gruppe ausgewählt ist, die aus Fettsäuren, Fettsäuresalzen und Fettsäureestern besteht, und (b) wenigstens eine aliphatische Kohlenwasserstoffverbindung enthält, und
(iii) die Sandwichanordnung sintert.

Ferner stellt die Erfindung gattungsgemäß eine Paste zur Verfügung, enthaltend (a) Metallpartikel, die ein Coating aufweisen, das wenigstens eine Verbindung umfasst, die aus der Gruppe ausgewählt ist, die aus Fettsäuren, Fettsäuresalzen und Fettsäureestern besteht, und (b) wenigstens eine aliphatische Kohlenwasserstoffverbindung.

Die aus dem Stand der Technik bekannten Pasten enthalten üblicherweise Metallpartikel, die gecoatet sind, um eine Agglomeration der Metallpartikel in der Paste zu vermeiden. Als Coatingverbindungen werden beispielsweise Siliciumdioxid, Metalloxide, Metalllegierungen, Polymere oder Fettsäuren eingesetzt. Mit diesen Coatingverbindungen lässt sich zwar eine Agglomeration wirksam vermeiden. Beim Sinterprozess erweist es sich jedoch als nachteilig, dass diese Coatingverbindungen die Diffusionsgeschwindigkeit erheblich verlangsamen und somit hohe Prozesstemperaturen erforderlich machen. Der Sintervorgang kann daher erst erfolgen, nachdem die Coatingverbindungen abgebrannt und die Oberflächen der Metallpartikel freigelegt sind.

Die Erfindung beruht auf der überraschenden Erkenntnis, dass die Sintertemperaturen erheblich reduziert werden können, wenn die in der Paste enthaltenen Metallpartikel ein Coating aus Fettsäure (oder einem Fettsäurederivat) aufweisen, und die Pasten zusätzlich aliphatische Kohlenwasserstoffe enthalten.

Ohne an eine Theorie gebunden sein zu wollen, scheinen aliphatische Kohlenwasserstoffverbindungen in der Lage zu sein, das Abbrennen der Fettsäuren von den Metallpartikeln bereits bei Temperaturen von unter 250°C zu begünstigen. Vermutlich werden bei Temperaturen von unter 250°C die aliphatischen Kohlenwasserstoffverbindungen zwischen die Oberfläche der Metallpartikel und der darüber liegenden Fettsäureschicht eingeschleppt, so dass die Fettsäuren von den aliphatischen Kohlenwasserstoffen umgeben und von diesen angelöst werden. Während dieser Prozess keine nachteiligen Auswirkungen im Hinblick auf eine Verhinderung der Agglomeration der Metallpartikel zeigt, führt dies offensichtlich zu einem Abbrennen der Fettsäuren bei Temperaturen unter 250°C, so dass die Oberflächen der Metallpartikel bereits bei diesen Temperaturen für den Sinterprozess zur Verfügung stehen. Ferner werden bei diesem Sinterprozess Kontaktschichten zwischen dem elektronischen Bauelement und dem Substrat geschaffen, die eine hohe Scherfestigkeit sowie eine gleichmäßige, reproduzierbare Güte hinsichtlich der Scherfestigkeit aufweisen. Darüber hinaus lässt sich durch den Einsatz der aliphatischen Kohlenwasserstoffverbindungen eine homogenere Verteilung der Bestandteile der Pasten erreichen als dies bei Pasten der Fall ist, die herkömmliche Lösungsmittel enthalten. Dies führt unter anderem zu einer gegenüber den aus dem Stand der Technik bekannten Pasten besseren Verarbeitbarkeit der erfindungsgemäßen Pasten.

Die erfindungsgemäß verwendete Paste enthält Metallpartikel. Diese Metallpartikel sind erfindungsgemäß Silberpartikel.

Das Metall weist vorzugsweise eine Reinheit von wenigstens 95 Gewichtsprozent, bevorzugt wenigstens 98 Gewichtsprozent, mehr bevorzugt wenigstens 99 Gewichtsprozent und noch mehr bevorzugt wenigstens 99,9 Gewichtsprozent auf.

Die in der Paste enthaltenen Metallpartikel können homogen oder heterogen hinsichtlich ihrer Zusammensetzung sein. Insbesondere können in der Paste Partikel aus unterschiedlichen Metallen enthalten sein.

Die Metallpartikel können von unterschiedlicher Gestalt sein. Beispielsweise können die Metallpartikel in der Form von Flakes oder einer sphärischen (kugeligen) Form vorliegen. Gemäß einer besonders bevorzugten Ausführungsform weisen die Metallpartikel die Form von Flakes auf. Dies schließt jedoch nicht aus, dass von den eingesetzten Metallpartikeln auch ein untergeordneter Anteil eine andere Form aufweisen kann. Es ist jedoch bevorzugt, dass wenigstens 70 Gewichtsprozent, mehr bevorzugt wenigstens 80 Gewichtsprozent, noch mehr bevorzugt wenigstens 90 Gewichtsprozent oder 100 Gewichtsprozent der Partikel in der Form von Flakes vorliegen.

Erfindungsgemäß sind die Metallpartikel gecoatet.

Unter einem Coating von Partikeln wird erfindungsgemäß eine festhaftende Schicht auf der Oberfläche von Partikeln verstanden. Erfindungsgemäß bedeutet festhaftende Schicht, dass sich die Schicht nicht bereits gravitationsbedingt von den Metallpartikeln löst.

Erfindungsgemäß enthält das Coating der Metallpartikel wenigstens eine Coatingverbindung.

Bei dieser wenigstens einen Coatingverbindung handelt es sich um eine Verbindung, die aus der Gruppe ausgewählt ist, die aus Fettsäuren, Fettsäuresalzen und Fettsäureestern besteht. Diese Coatingverbindungen sollen eine Agglomeration der in der Paste enthaltenen Metallpartikel vermeiden und zur Stabilisierung der Paste beitragen.

Die Coatingverbindungen sind vorzugsweise aus der Gruppe ausgewählt, die aus gesättigten Verbindungen, einfach ungesättigten Verbindungen, mehrfach ungesättigten Verbindungen und Mischungen davon besteht.

Die Coatingverbindungen sind ferner vorzugsweise aus der Gruppe ausgewählt, die aus verzweigten Verbindungen, unverzweigten Verbindungen und Mischungen davon besteht.

Die Coatingverbindungen weisen vorzugsweise 8 - 28, noch mehr bevorzugt 12 - 24 und besonders bevorzugt 12 - 18 Kohlenstoffatome auf.

Gemäß einer bevorzugten Ausführungsform handelt es sich bei den Coatingverbindungen um Monofettsäuren, Salze von Monofettsäuren oder Monofettsäureester.

Als Fettsäuresalze kommen vorzugsweise Salze in Betracht, deren anionische Komponente die deprotonierte Fettsäure darstellt, und deren kationische Komponente aus der Gruppe ausgewählt ist, die aus Ammoniumionen, Monoalkylammoniumionen, Dialkylammoniumionen, Trialkylammoniumionen, Lithiumionen, Natriumionen, Kaliumionen, Kupferionen und Aluminiumionen besteht.

Bevorzugte Fettsäureester leiten sich von den entsprechenden Fettsäuren ab, wobei die Hydroxylgruppen der Säureeinheiten durch Alkylgruppen, insbesondere Methylgruppen, Ethylgruppen, Propylgruppen oder Butylgruppen, ersetzt sind.

Gemäß einer bevorzugten Ausführungsform ist die wenigstens eine Coatingverbindung aus der Gruppe ausgewählt, die aus Caprylsäure (Octansäure), Caprinsäure (Decansäure), Laurinsäure (Dodecansäure), Myristinsäure (Tetradecansäure), Palmitinsäure (Hexadecansäure), Stearinsäure (Octadecansäure), Mischungen davon, sowie den entsprechenden Estern und Salzen sowie Mischungen davon, besteht.

Gemäß einer besonders bevorzugten Ausführungsform ist die wenigstens eine Coatingverbindung aus der Gruppe ausgewählt, die aus Laurinsäure (Dodecansäure), Stearinsäure (Octadecansäure), Natriumstearat, Kaliumstearat, Aluminiumstearat, Kupferstearat, Natriumpalmitat und Kaliumpalmitat besteht.

Die erfindungsgemäß verwendeten Metallpartikel sind kommerziell erhältlich. Die entsprechenden Coatingverbindungen können mittels herkömmlicher und aus dem Stand der Technik bekannter Verfahren auf die Oberfläche der Metallpartikel aufgetragen werden.

Beispielsweise ist es möglich, die Coatingverbindungen, insbesondere die vorstehend erwähnten Stearate oder Palmitate, in Lösungsmitteln aufzuschlämmen und die aufgeschlämmten Coatingverbindungen in Kugelmühlen mit den Metallpartikeln zu vermahlen. Nach dem Mahlen werden die nun mit den Coatingverbindungen beschichteten Metallpartikel getrocknet und anschließend entstaubt.

Vorzugsweise beträgt der Anteil der wenigstens einen Coatingverbindung, die aus der Gruppe ausgewählt ist, die aus Fettsäuren, Fettsäuresalzen und Fettsäureestern besteht, bezogen auf das Gesamtgewicht des Coatings, wenigstens 80 Gewichtsprozent, mehr bevorzugt wenigstens 90 Gewichtsprozent, besonders bevorzugt wenigstens 95 Gewichtsprozent, ganz besonders bevorzugt wenigstens 99 Gewichtsprozent und insbesondere 100 Gewichtsprozent.

Gemäß einer bevorzugten Ausführungsform beträgt der Anteil der Coatingverbindungen 0,05 - 3 Gewichtsprozent, mehr bevorzugt 0,07 - 2,5 Gewichtsprozent und noch mehr bevorzugt 0,1 - 2,2 Gewichtsprozent, bezogen auf das Gewicht der gecoateten Metallpartikel.

Der Coatinggrad, der als Verhältnis der Masse an Coatingverbindungen zur Oberfläche der Metallpartikel definiert ist, beträgt vorzugsweise 0,00005 - 0,03 g, mehr bevorzugt 0,0001 - 0,02 g und noch mehr bevorzugt 0,0005 - 0,02 g an Coatingverbindungen pro Quadratmeter (m²) Oberfläche der Metallpartikel.

Die Paste erhält erfindungsgemäß wenigstens eine aliphatische Kohlenwasserstoffverbindung.

Unter aliphatischen Kohlenwasserstoffverbindungen werden erfindungsgemäß Verbindungen verstanden, die aus Kohlenstoffatomen und Wasserstoffatomen zusammengesetzt und nicht aromatisch sind. Die erfindungsgemäßen aliphatischen Kohlenwasserstoffverbindungen enthalten somit keine Heteroatome.

Die wenigstens eine aliphatische Kohlenwasserstoffverbindung scheint in der Lage zu sein, ein Abbrennen der als Coatingverbindungen auf den Metallpartikeln enthaltenen Fettsäuren oder Fettsäure-Derivaten bei Temperaturen von unter 250°C zu begünstigen, so dass die reaktiven Oberflächen der Metallpartikel bereits bei tieferen Temperaturen für den Sinterprozess zur Verfügung stehen. Dadurch kann eine deutliche Erniedrigung der Sintertemperatur erreicht werden.

Ferner kann die wenigstens eine aliphatische Kohlenwasserstoffverbindung als Lösungsmittelersatz dienen und aufgrund ihrer unpolaren Natur Wassereinlagerungen effektiv unterbinden.

Die wenigstens eine aliphatische Kohlenwasserstoffverbindung ist vorzugsweise aus der Gruppe ausgewählt, die aus gesättigten Verbindungen, einfach ungesättigten, mehrfach ungesättigten Verbindungen und Mischungen davon besteht. Gemäß einer besonders bevorzugten Ausführungsform ist die aliphatische Kohlenwasserstoffverbindung aus der Gruppe ausgewählt, die aus gesättigten aliphatischen Kohlenwasserstoffverbindungen besteht.

Bei der wenigstens einen aliphatischen Kohlenwasserstoffverbindung kann es sich ferner um eine zyklische oder azyklische Verbindung handeln.

Gemäß einer bevorzugten Ausführungsform ist die wenigstens eine aliphatische Kohlenwasserstoffverbindung aus der Gruppe ausgewählt, die aus n-Alkanen, Isoalkanen, Cycloalkanen und Mischungen davon besteht.

Die erfindungsgemäß eingesetzte, wenigstens eine aliphatische Kohlenwasserstoffverbindung weist vorzugsweise 5 - 32 Kohlenstoffatome, mehr bevorzugt 10 - 25 Kohlenstoffatome und noch mehr bevorzugt 16 - 20 Kohlenstoffatome auf.

Gemäß einer bevorzugten Ausführungsform ist die aliphatische Kohlenwasserstoffverbindung aus der Gruppe ausgewählt, die aus gesättigten Kohlenwasserstoffen besteht, die durch die Formeln CₙH₂ₙ₊₂, CₙH₂ₙ und CₙH₂ₙ-₂ dargestellt sind, wobei n für eine ganze Zahl zwischen 5 und 32, vorzugsweise zwischen 10 und 25 und mehr bevorzugt zwischen 16 und 20 steht.

Gemäß einer ganz besonders bevorzugten Ausführungsform ist die wenigstens eine aliphatische Kohlenwasserstoffverbindung aus der Gruppe ausgewählt, die aus Hexadecan, Octadecan, Isohexadecanen, Isooctadecanen, Cyclohexadecanen und Cyclooctadecanen besteht. Beispielsweise kann es sich bei der wenigstens einen aliphatischen Kohlenwasserstoffverbindung um eine Mischung aus aliphatischen Kohlenwasserstoffverbindungen handeln, wie sie beispielsweise von Exxon Mobil unter der Marke Exxsol™ D140 oder unter der Marke Isopar M™ vertrieben wird.

Die erfindungsgemäße Paste enthält vorzugsweise 75 - 90 Gewichtsprozent, mehr bevorzugt 77 - 89 Gewichtsprozent und noch mehr bevorzugt 80 - 88 Gewichtsprozent an Metallpartikeln, bezogen auf das Gesamtgewicht der Paste.

Gemäß einer bevorzugten Ausführungsform enthält die Paste 0,05 - 2,5 Gewichtsprozent, mehr bevorzugt 0,07 - 2,2 Gewichtsprozent und noch mehr bevorzugt 0,1 - 2 Gewichtsprozent an wenigstens einer Coatingverbindung, die aus der Gruppe ausgewählt ist, die aus Fettsäuren, Fettsäuresalzen und Fettsäureestern besteht, bezogen auf das Gesamtgewicht der Paste.

Der Anteil der wenigstens einen aliphatischen Kohlenwasserstoffverbindung an der Paste ist nicht besonders eingeschränkt. Um eine gute Verarbeitbarkeit der Paste zu erreichen, kann es von Vorteil sein, dass die Paste 3 - 25 Gewichtsprozent, mehr bevorzugt 4 - 20 Gewichtsprozent und noch mehr bevorzugt 5 - 18 Gewichtsprozent an der wenigstens einen aliphatischen Kohlenwasserstoffverbindung, bezogen auf das Gesamtgewicht der Paste, enthält.

Als besonders vorteilhaft hat es sich herausgestellt, die wenigstens eine aliphatische Kohlenwasserstoffverbindung in der Paste in einer Menge vorzusehen, die groß genug ist, um ein einfaches Abbrennen der Coatingverbindungen bei Temperaturen unter 250°C zu ermöglichen. Dementsprechend beträgt das Verhältnis des Gewichtsanteils der Coatingverbindungen zum Gewichtsanteil der wenigstens einen aliphatischen Kohlenwasserstoffverbindung höchstens 0,1 %.

Andererseits muss die Menge an aliphatischen Kohlenwasserstoffen auch nicht besonders hoch relativ zu der Menge an Coatingverbindungen gewählt werden, damit die erfindungsgemäßen Effekte erreicht werden. Gemäß einer besonders bevorzugten Ausführungsform liegt das Verhältnis des Gewichtsanteils der Coatingverbindungen zum Gewichtsanteil der wenigstens einen aliphatischen Kohlenwasserstoffverbindung demnach im Bereich von 0,001 - 1,0, mehr bevorzugt im Bereich von 0,005 - 0,85 und noch mehr bevorzugt im Bereich von 0,01 - 0,7.

Gemäß einer weiteren bevorzugten Ausführungsform liegt das molare Verhältnis des Hauptbestandteils des Coatings, der aus der Gruppe ausgewählt ist, die aus Fettsäuren, Fettsäuresalzen und Fettsäureestern besteht, zum Hauptbestandteil der wenigstens einen aliphatischen Kohlenwasserstoffverbindung im Bereich von 0,001 - 1,0, mehr bevorzugt im Bereich von 0,005 - 0,85 und noch mehr bevorzugt im Bereich von 0,01 - 0,7. Unter molarem Verhältnis wird im Rahmen der Erfindung das Verhältnis der Stoffmengen der jeweiligen, in der Paste enthaltenen Bestandteile verstanden. Erfindungsgemäß wird der Hauptbestandteil des Coatings von der Coatingverbindung, die aus der Gruppe ausgewählt ist, die aus Fettsäuren, Fettsäuresalzen und Fettsäureestern besteht, gebildet, die in einer größeren Menge vorliegt als gegebenenfalls andere enthaltene Coatingverbindungen, die aus der Gruppe ausgewählt sind, die aus Fettsäuren, Fettsäuresalzen und Fettsäureestern besteht. Erfindungsgemäß wird der Hauptbestandteil der wenigstens einen aliphatischen Kohlenwasserstoffverbindung von der aliphatischen Kohlenwasserstoffverbindung gebildet, die in einer größeren Menge vorliegt als gegebenenfalls andere enthaltene aliphatische Kohlenwasserstoffverbindungen.

Überraschenderweise wurde festgestellt, dass die Erniedrigung der Sintertemperatur, die erfindungsgemäß angestrebt wird, einerseits mit der Länge der Hauptkette der Fettsäure bzw. des Fettsäurederivats, die hauptsächlich im Coating der Metallpartikel enthalten ist, und andererseits mit der Länge der Hauptkette der aliphatischen Kohlenwasserstoffverbindung, die die wenigstens eine aliphatische Kohlenwasserstoffverbindung oder die Hauptkomponente der Mischung aus den aliphatischen Kohlenwasserstoffverbindungen darstellt, im Zusammenhang steht. So wurde gefunden, dass eine besonders starke Erniedrigung der Sintertemperatur erreicht werden kann, wenn die Hauptketten dieser Fettsäure bzw. dieses Fettsäurederivats und r dieser aliphatischen Kohlenwasserstoffverbindung dieselbe oder eine ähnliche Anzahl an Kohlenstoffatomen aufweisen.

Das Verhältnis der Kohlenstoffatome, die in der Hauptkette des Hauptbestandteils des Coatings enthalten sind, zu den Kohlenstoffatomen, die in der Hauptkette des Hauptbestandteils der wenigstens einen aliphatischen Kohlenwasserstoffverbindung enthalten sind, liegt im Bereich von 0,6 - 1,4, bevorzugt im Bereich von 0,8 -1,2 und ganz besonders bevorzugt im Bereich von 0,85 - 1,15.

Weisen die Metallpartikel beispielsweise ein Coating auf, das eine Mischung aus 20 Gewichtsprozent Laurinsäure (eine Fettsäure mit einer Hauptkette, die 12 Kohlenstoffatome aufweist), 35 Gewichtsprozent Myristinsäure (eine Fettsäure mit einer Hauptkette, die 14 Kohlenstoffatome aufweist) und 45 Gewichtsprozent Kaliumstearat (ein Salz einer Fettsäure mit einer Hauptkette, die 18 Kohlenstoffatome aufweist) enthält, so ist Kaliumstearat der Hauptbestandteil des Coatings. In diesem Fall kann eine außergewöhnliche Erniedrigung der Sintertemperatur erreicht werden, wenn die einzige aliphatische Kohlenwasserstoffverbindung oder der Hauptbestandteil einer Mischung aus aliphatischen Kohlenwasserstoffverbindungen eine Hauptkette mit einer ähnlichen oder identischen Anzahl an Kohlenstoffatomen aufweist. Demnach wäre es bevorzugt, wenn die einzige aliphatische Kohlenwasserstoffverbindung oder der Hauptbestandteil einer Mischung aus aliphatischen Kohlenwasserstoffverbindungen eine Hauptkette mit 16 - 20 Kohlenstoffatomen, insbesondere mit 18 Kohlenstoffatomen, ist.

Die erfindungsgemäße Paste kann neben den vorstehend genannten Bestandteilen weitere Stoffe enthalten.

Gemäß einer bevorzugten Ausführungsform enthält die Paste wenigstens einen Metallprecursor.

Unter Metallprecursor wird im Rahmen der Erfindung eine Verbindung verstanden, die bei Temperaturen von unter 250°C in Gegenwart der in der Paste enthaltenen Metallpartikel zu dem Metall des Metallprecursors zersetzt wird. Vorzugsweise wird demnach bei Verwendung eines Metallprecursors beim Sinterprozess *in situ* ein Metall gebildet. Es kann auf einfache Weise ermittelt werden, ob es sich bei einer Verbindung um einen Metallprecursor gemäß dieser bevorzugten Ausführungsform handelt. So kann beispielsweise eine Paste, die eine zu testende Verbindung enthält, auf ein Substrat mit einer Silberoberfläche abgeschieden, auf 250°C erhitzt und bei dieser Temperatur für 20 Minuten belassen werden. Danach wird überprüft, ob sich unter diesen Bedingungen die zu testende Verbindung zu einem Metall zersetzt hat. Hierzu kann beispielsweise vor dem Test der Gehalt der metallhaltigen Pastenbestandteile ausgewogen und daraus die theoretische Masse des Metalls berechnet werden. Nach dem Test wird die Masse des auf dem Substrat abgeschiedenen Materials gravimetrisch bestimmt. Entspricht die Masse des auf dem Substrat abgeschiedenen Materials der theoretischen Masse des Metalls, wobei die üblichen Messabweichungen zu berücksichtigen sind, handelt es sich bei der getesteten Verbindung um einen Metallprecursor gemäß dieser bevorzugten Ausführungsform.

Gemäß einer weiteren bevorzugten Ausführungsform weist der Metallprecursor ein Metall auf, das auch in den Metallpartikeln enthalten ist. Gemäß einer besonders bevorzugten Ausführungsform weist der Metallprecursor daher Silber oder Kupfer als Metall auf.

Es kann bevorzugt sein, als Metallprecursor Metallcarbonate, Metalllactate, Metallformiate, Metallcitrate, Metalloxide oder Metall-Fettsäuresalze, vorzugsweise Fettsäuresalze mit 6 bis 24 Kohlenstoffatomen, zu verwenden.

In besonderen Ausführungsformen werden als Metallprecursor Silbercarbonat, Silberlactat, Silberformiat, Silbercitrat, Silberoxid (zum Beispiel AgO oder Ag₂O Kupferlactat, Kupferstearat, Kupferoxide (zum Beispiel Cu₂O oder CuO), Goldoxide (zum Beispiel Au₂O oder AuO) oder Mischungen davon eingesetzt.

Gemäß einer besonders bevorzugten Ausführungsform wird der Metallprecursor aus der Gruppe ausgewählt, die aus Silbercarbonat und Silberoxiden besteht.

Falls vorhanden, liegt der Metallprecursor in der Paste vorzugsweise in partikulärer Form, besonders bevorzugt in der Form von Flakes, vor.

Die Verwendung eines Metallprecursors, der während des Sinterprozesses *in situ* Metall freisetzt, hat zur Folge, dass das *in situ* gebildete Metall während des Sinterprozesses Lücken zwischen den in der Paste enthaltenen Metallpartikeln schließt. Auf diese Weise kann die Porosität einer Kontaktstelle zwischen zwei zu verbindenden Bauelementen reduziert werden.

Die Paste kann auch wenigstens ein Sinterhilfsmittel enthalten. Dieses Sinterhilfsmittel ist vorzugsweise in der Lage, während des Sinterprozesses bei Temperaturen unter 250°C ein Abbrennen der Coatingverbindungen bei unter 250°C zu gewährleisten, um so ein Sintern bei Temperaturen von unter 250°C zu ermöglichen. Besonders geeignete Sinterhilfsmittel gewährleisten ein Abbrennen der Coatingverbindungen bei Temperaturen unter 250°C entweder direkt oder indirekt durch intermediär gebildete Verbindungen.

Gemäß einer bevorzugten Ausführungsform kann das Sinterhilfsmittel ein Oxidationsmittel sein. Unter Oxidationsmittel ist ein Stoff zu verstehen, der andere Stoffe oxidieren kann und dabei selbst reduziert wird. Ein Oxidationsmittel kann Elektronen aufnehmen und ist somit ein Elektronenakzeptor. Vorzugsweise ist das Sinterhilfsmittel auch ein Sauerstoffüberträger. Damit ist ein Stoff gemeint, der Sauerstoff abgeben kann. Gemäß dieser Ausführungsform können als Sinterhilfsmittel beispielsweise (i) organische Peroxide (wie zum Beispiel Cumylperoxid), (ii) anorganische Peroxide und (iii) anorganische Säuren eingesetzt werden. Diese Verbindungen können als Sinterhilfsmittel dienen, da sie wenigstens ein Sauerstoffatom enthalten und ein Verbrennen der Coatingverbindungen, die auf den Metallpartikeln der Paste vorhanden sind, bei einer Temperatur von unter 250°C ermöglichen.

Gemäß einer weiteren bevorzugten Ausführungsform kann das Sinterhilfsmittel auch gewährleisten, dass den Sinterprozess störende Metalloxide, die auf der Oberfläche der in der Paste enthaltenen Metallpartikel vorhandenen sein können, reduziert werden. Aus diesem Grund können als Sinterhilfsmittel auch Verbindungen eingesetzt werden, die im Laufe des Sinterprozesses ein Reduktionsmittel freisetzen. Bei diesem Reduktionsmittel handelt es sich vorzugsweise um Kohlenmonoxid. Gemäß dieser Ausführungsform kann das Sinterhilfsmittel beispielsweise aus der Gruppe ausgewählt sein, die aus (iv) Salzen von organischen Säuren, wobei die organischen Säuren 1 - 4 Kohlenstoffatome aufweisen (wie zum Beispiel Aluminiumformiat), (v) Estern von organischen Säuren, wobei die organischen Säuren 1 - 4 Kohlenstoffatome aufweisen, und (vi) Carbonylkompiexen besteht. Diese Verbindungen können als Sinterhilfsmittel dienen, indem sie während des Sinterprozesses Kohlenmonoxid freisetzen oder an der Freisetzung von Kohlenmonoxid beteiligt sind und so eine Reduktion der Metalloxide, die auf der Oberfläche der in der Metallpaste enthaltenen Metallpartikel enthalten sind, zu dem entsprechenden Metall bei einer Temperatur von unter 250°C ermöglichen.

Die Paste kann neben der aliphatischen Kohlenwasserstoffverbindung weitere Verbindungen enthalten, die als Lösungsmittel wirken können. Hierfür kommen die üblicherweise für Metallpasten verwendeten Lösungsmittel in Betracht. Beispielsweise können als Lösungsmittel α-Terpineol ((R)-(+)-α-Terpineol, (S)-(-)-α-Terpineol oder Racemate), β-Terpineol, y-Terpineol, δ-Terpineol, Mischungen der vorstehend genannten Terpineole, N-Methyl-2-pyrrolidon, Ethylenglycol, Dimethylacetamid, 1-Tridecanol, 2-Tridecanol, 3-Tridecanol, 4-Tridecanol, 5-Tridecanol, 6-Tridecanol, Isotridecanol, dibasische Ester (vorzugsweise Dimethylester der Glutar-, Adipin- oder Bernsteinsäure oder Mischungen davon), Glycerin, Diethylenglycol, Triethylenglycol oder Mischungen hiervon zum Einsatz kommen. Es kann jedoch auch bevorzugt sein, dass in der Metallpaste neben den aliphatischen Kohlenwasserstoffen keine Lösungsmittel oder aber nur in geringen Mengen vorhanden sind. Beispielsweise kann es von Vorteil sein, dass der Anteil an weiteren Lösungsmitteln in der Metallpaste bei höchstens 10 Gewichtsprozent, mehr bevorzugt höchstens 5 Gewichtsprozent, noch mehr bevorzugt höchstens 3 Gewichtsprozent und besonders bevorzugt höchstens 1 Gewichtsprozent liegt. Gemäß einer weiteren bevorzugten Ausführungsform liegt der Anteil an aliphatischen Kohlenwasserstoffen, bezogen auf das Gesamtgewicht von aliphatischen Kohlenwasserstoffen und weiteren Lösungsmitteln, im Bereich von 30 - 100 Gewichtsprozent, mehr bevorzugt im Bereich von 50 - 100 Gewichtsprozent, noch mehr bevorzugt im Bereich von 70 - 100 Gewichtsprozent und besonders bevorzugt im Bereich von 80 - 100 Gewichtsprozent.

Die Paste kann ferner wenigstens ein Polymer enthalten, um der Paste gewünschte Eigenschaften zu verleihen. Andererseits kann es jedoch von Vorteil sein, dass die Paste keine Polymere enthält oder deren Anteil gering ist, da Polymere, insbesondere Duroplasten, üblicherweise bei Temperaturen von mehr als 250°C ausbrennen und sich daher nachteilig auf die Sinterfähigkeit der Paste auswirken. Dies gilt insbesondere für Duroplasten oder Vorprodukte davon. Unter Vorprodukten von Duroplasten werden Verbindungen verstanden, die in Gegenwart weiterer Pastenbestandteile zu Duroplasten aushärten können. Diese Duroplasten oder Vorprodukte davon weisen üblicherweise ein gewichtsmittleres Molekulargewicht von weniger als 700 auf. Gemäß einer bevorzugten Ausführungsform beträgt der Anteil an Polymeren, die ein gewichtsmittleres Molekulargewicht von weniger als 700 aufweisen, nicht mehr als 6 Gewichtsprozent, bezogen auf das Gesamtgewicht der Paste.

Darüber hinaus können in der Metallpaste weitere Inhaltsstoffe, wie zum Beispiel übliche Dispersionsmittel, Tenside, Entschäumer, Bindemittel oder viskositätssteuernde Mittel, enthalten sein.

Die vorstehend beschriebenen Pasten können erfindungsgemäß eingesetzt werden, um ein elektronisches Bauelement auf einem Substrat zu befestigen.

Diese Befestigung erfolgt vorzugsweise durch Sintern. Unter Sintern wird erfindungsgemäß das Verbinden von zwei oder mehr Bauelementen durch Erhitzen unter Umgehung der flüssigen Phase verstanden.

Unter elektronischem Bauelement wird in allgemeiner Art ein Gegenstand verstanden, der Teil einer elektronischen Anordnung sein kann. Gemäß einer bevorzugten Ausführungsform wird darunter ein nicht weiter zerlegbares Einzelteil verstanden, das als Bestandteil einer elektronischen Schaltung dienen kann. Das elektronische Bauelement kann als Einheit gegebenenfalls aus mehreren Bauteilen bestehen. Bei dem elektronischen Bauelement kann es sich beispielsweise um ein aktives Bauelement oder ein passives Bauelement handeln. Gemäß besonderen Ausführungsformen werden die elektronischen Bauelemente in der Hochleistungselektronik verwendet. Gemäß einer bevorzugten Ausführungsform ist das elektronische Bauelement aus der Gruppe ausgewählt, die aus Dioden (zum Beispiel LEDs, *Light Emitting Diodes*, lichtemittierende Dioden), Transistoren (zum Beispiel IGBTs, *Insulated-Gate Bipolar Transistors,* Bipolartransistoren mit isolierter Gate-Elektrode), integrierten Schaltungen, Halbleiterchips, Nacktchips (Dies), Widerständen, Sensoren, Kondensatoren, Spulen und Kühlkörpern besteht.

Unter Substrat wird in allgemeiner Form ein Gegenstand verstanden, der mit einem elektronischen Bauelement verbindbar ist. Gemäß einer bevorzugten Ausführungsform ist das Substrat aus der Gruppe ausgewählt, die aus Leadframes, DCB-Substraten (*Direct-Copper-Bonded-*Substraten) und keramischen Substraten besteht.

Gemäß einer bevorzugten Ausführungsform werden folgende Paare aus elektronischem Bauelement und Substrat aufeinander befestigt: LED/Leadframe, LED/keramisches Substrat, *Die*/Leadframe, *Die*/keramisches Substrat, *Die*/DCB-Substrat, Diode/Leadframe, Diode/keramisches Substrat, Diode/DCB-Substrat, IGBT/Leadframe, IGBT/keramisches Substrat, IGBT/DCB-Substrat, integrierte Schaltung/Leadframe, integrierte Schaltung/keramisches Substrat, integrierte Schaltung/DCB-Substrat, Sensor/Leadframe, Sensor/keramisches Substrat, Kühlkörper (vorzugsweise Kupfer- oder Aluminiumkühlkörper)/DCB, Kühlkörper (vorzugsweise Kupfer- oder Aluminiumkühlkörper)/keramisches Substrat, Kühlkörper/Leadframe, Kondensator (vorzugsweise Tantalkondensator, mehr bevorzugt in ungehäustem Zustand)/Leadframe.

Gemäß einer weiteren bevorzugten Ausführungsform können mit dem Substrat mehrere elektronische Bauelemente verbunden werden. Es kann ferner bevorzugt sein, dass sich elektronische Bauelemente auf gegenüberliegenden Seiten des Substrats befinden.

Elektronisches Bauelement, Substrat oder elektronisches Bauelement und Substrat können ferner wenigstens eine Metallisierungsschicht umfassen. Diese Metallisierungsschicht kann beispielsweise reines Metall oder eine Metalllegierung aufweisen. Weist die Metallisierungsschicht ein Metall auf, so ist dieses vorzugsweise aus der Gruppe ausgewählt, die aus Kupfer, Silber, Gold, Palladium und Platin besteht. Weist die Metallisierungsschicht eine Metalllegierung auf, so enthält diese vorzugsweise wenigstens ein Metall, das aus der Gruppe ausgewählt ist, die aus Silber, Gold, Nickel, Palladium und Platin besteht. Die Metallisierungsschicht kann auch einen mehrlagigen Aufbau aufweisen. Gemäß einer weiteren bevorzugten Ausführungsform enthält die Metallisierungsschicht auch ein Glas.

Erfindungsgemäß wird das elektronische Bauelement auf dem Substrat durch Sintern befestigt. In diesem Zusammenhang bedeutet "auf" lediglich, dass eine Oberfläche des elektronischen Bauelements mit einer Oberfläche des Substrats verbunden ist, wobei es auf die relative Lage des elektronischen Bauelements, des Substrats oder der Anordnung nicht ankommt.

Erfindungsgemäß werden zum Sintern das elektronische Bauelement und das Substrat miteinander in Kontakt gebracht. Das Kontaktieren erfolgt dabei über die erfindungsgemäße Paste. Gemäß einer bevorzugten Ausführungsform weisen sowohl elektronisches Bauelement und Substrat eine Metallisierungsschicht auf, wobei die Metallisierungsschicht des elektronischen Bauelements und die Metallisierungsschicht des Substrats über die Paste miteinander in Kontakt stehen. Erfindungsgemäß wird zunächst eine Sandwichanordnung geschaffen, die das elektronische Bauelement, das Substrat und eine dazwischen angeordnete Schicht aufweist, die die erfindungsgemäße Paste enthält. Unter Sandwichanordnung ist vorzugsweise eine Anordnung zu verstehen, bei der sich das elektronische Bauelement über dem Substrat oder das Substrat über dem elektronischen Bauelement befindet und elektronisches Bauelement und Substrat im Wesentlichen parallel zueinander angeordnet sind.

Die Sandwichanordnung aus dem elektronischen Bauelement, dem Substrat und der dazwischen liegenden Paste kann nach einem aus dem Stand der Technik bekannten Verfahren hergestellt werden. Vorzugsweise wird zunächst wenigstens eine Oberfläche des Substrats, vorzugsweise eine mit einer Metallisierungsschicht versehene Oberfläche des Substrats, mit der erfindungsgemäßen Paste bestückt. Die Auftragung der Paste auf die Oberfläche des Substrats kann mittels herkömmlicher Verfahren erfolgen. Vorzugsweise erfolgt die Auftragung der Paste mittels Druckverfahren, so zum Beispiel mittels Siebdruck oder Schablonendruck. Andererseits kann die Auftragung der Paste auch mittels Dispenstechnik, mittels Spraytechnik, mittels Pintransfer oder durch Dippen erfolgen. Anschließend wird das elektronische Bauelement mit einer seiner Oberflächen, vorzugsweise mit einer Oberfläche, die eine Metallisierungsschicht aufweist, auf die Paste, die auf die Oberfläche des Substrats aufgetragen worden ist, aufgesetzt. Somit befindet sich zwischen dem Substrat und dem elektronischen Bauelement, vorzugsweise zwischen der Metallisierungsschicht des Substrats und der Metallisierungsschicht des elektronischen Bauelements, eine Pastenschicht.

Die Nassschichtdicke zwischen Substrat und elektronischem Bauelement liegt vorzugsweise im Bereich von 20 - 200 µm. Unter Nassschichtdicke wird vorzugsweise der Abstand zwischen den sich gegenüberstehenden Oberflächen von Substrat und elektronischem Bauelement verstanden. Die bevorzugte Nasssichtdicke ist abhängig vom gewählten Verfahren zum Auftragen der Metallpaste. Wird die Metallpaste beispielsweise mittels Siebdruckverfahren aufgetragen, dann kann eine Nassschichtdicke von 20 - 50 µm bevorzugt sein. Erfolgt die Auftragung der Metallpaste mittels Schablonendruck, dann kann die bevorzugte Nassschichtdicke im Bereich von 50 - 200 µm liegen.

Gemäß einer bevorzugten Ausführungsform wird vor dem Sinterprozess ein Trocknungsschritt durchgeführt. Unter Trocknung wird vorzugsweise eine Verringerung des Anteils des Lösungsmittels in der Metallpaste verstanden. Gemäß einer bevorzugten Ausführungsform liegt der Anteil des Lösungsmittels in der Metallpaste nach der Trocknung im Bereich von 1 - 5 Gewichtsprozent, bezogen auf das Gewicht der getrockneten Metallpaste.

Die Trocknung kann einerseits nach der Herstellung der Sandwichanordnung erfolgen. Andererseits kann die Trocknung aber auch unmittelbar nach dem Auftragen der Paste auf die wenigstens eine Oberfläche von Substrat bzw. elektronischem Bauelement und vor der Kontaktierung mit dem zu verbindenden elektronischen Bauelement bzw. Substrat erfolgen. Die Trocknungstemperatur liegt vorzugsweise im Bereich von 50 - 100°C. Es versteht sich, dass die Trocknungszeit abhängig ist von der jeweiligen Zusammensetzung der Paste und der Größe der zu sinternden Sandwichanordnung. Übliche Trocknungszeiten liegen jedoch im Bereich von 5 - 45 Minuten.

Die Sandwichanordnung aus dem elektronischen Bauelement, dem Substrat und der dazwischen angeordneten Schicht, die die erfindungsgemäße Paste enthält, wird schließlich einem Sinterprozess unterzogen. Bei diesem Sinterprozess handelt es sich um einen Niedertemperatursinterprozess. Unter Niedertemperatursinterprozess ist erfindungsgemäß ein Sinterprozess zu verstehen, der vorzugsweise bei einer Temperatur von unter 250°C, mehr bevorzugt bei einer Temperatur von unter 220°C, noch mehr bevorzugt bei einer Temperatur von unter 200°C und besonders bevorzugt bei einer Temperatur von unter 180°C abläuft.

Der Prozessdruck beim Sintern liegt vorzugsweise unter 30 MPa, mehr bevorzugt unter 5 MPa und noch mehr bevorzugt unter 1 MPa. Aufgrund der Verwendung der erfindungsgemäßen Paste gelingt das Sintern sogar ohne jegliche Anwendung von Prozessdruck, also bei einem Prozessdruck von 0 MPa.

Die Sinterzeit ist abhängig vom Prozessdruck und liegt vorzugsweise im Bereich von 2 - 45 Minuten.

Erfindungsgemäß kann der Sinterprozess in einer Atmosphäre erfolgen, die nicht weiter eingeschränkt ist. Vorzugsweise wird das Sintern jedoch in einer Atmosphäre durchgeführt, die Sauerstoff enthält.

Das Sintern wird in einer herkömmlichen, zum Sintern geeigneten Vorrichtung durchgeführt, in der sich vorzugsweise die vorstehend beschriebenen Prozessparameter einstellen lassen.

Die Erfindung wird im Folgenden anhand der nachstehend aufgeführten Beispiele erläutert, die jedoch nicht als einschränkend verstanden werden sollen.

### Beispiele:

### Beispiel 1:

Eine erfindungsgemäße Metallpaste, Paste 1, wurde hergestellt, indem
83 Gewichtsprozent Silberpartikel, die in der Form von Flakes vorlagen und mit Stearinsäure beschichtet waren, und
17 Gewichtsprozent Isopar M™, einem Petroleumdestillat, das hauptsächlich aus Isoparaffinen mit 12 - 15 Kohlenstoffatomen besteht,
zu einer homogenen Paste verrührt wurden.

Auf ein DCB (*Direct Copper Bonded*)-Substrat wurden Depots aus Paste 1 mit einer Dicke von 50 µm gedruckt, die danach mit IGBT (I*nsulated-Gate Bipolar Transistor)*-Chips mit einer Grundfläche von 100 mm² bestückt wurden, um eine Sandwichanordnung aus Substrat, Paste 1 und Chip zu schaffen. Diese Sandwichanordnung wurde bei einer Temperatur von 100°C für 5 Minuten im Umlufttrockenschrank getrocknet.

Die getrocknete Sandwichanordnung wurde schließlich bei einer Temperatur von 200°C und einem Druck von 10 MPa für einen Zeitraum von 2 Minuten gesintert.

Dieser Versuch wurde mehrmals unter denselben Bedingungen durchgeführt.

### Vergleichsbeispiel 1:

Eine Vergleichspaste, Vergleichspaste 1, wurde hergestellt, indem
83 Gewichtsprozent Silberpartikel, die in der Form von Flakes vorlagen und mit Stearinsäure beschichtet waren,
9 Gewichtsprozent Terpineol und
8 Gewichtsprozent Tridecanol
zu einer homogenen Paste verrührt wurden.

Auf ein DCB (*Direct Copper* Bonded)-Substrat wurden Depots aus Vergleichspaste 1 mit einer Dicke von 50 µm gedruckt, die danach mit IGBT (*Insulated-Gate Bipolar Transistor)-*Chips mit einer Grundfläche von 100 mm² bestückt wurden, um eine Sandwichanordnung aus Substrat, Vergleichspaste 1 und Chip zu schaffen. Diese Sandwichanordnung wurde bei einer Temperatur von 100°C für 5 Minuten im Umlufttrockenschrank getrocknet.

Die getrocknete Sandwichanordnung wurde schließlich bei einer Temperatur von 200°C und einem Druck von 10 MPa für einen Zeitraum von 2 Minuten gesintert.

Dieser Versuch wurde mehrmals unter denselben Bedingungen durchgeführt.

### Vergleich der in Beispiel 1 und Vergleichsbeispiel 1 erhaltenen Kontaktschichten:

Die Zuverlässigkeit der in Beispiel 1 bzw. Vergleichsbeispiel 1 erhaltenen Kontaktschichten zwischen Substrat und Chip wurde mittels eines Schältests (beschrieben in Mertens, Christian: Die Niedertemperatur-Verbindungstechnik der Leistungselektronik, Fortschr.-Ber. VDI Reihe 21 Nr. 365, Düsseldorf, VDI Verlag 2004, Kapitel 4.2) bestimmt. Dabei stellte sich heraus, dass die durch Verwendung von Paste 1 erhaltenen Kontaktschichten gegenüber den durch Verwendung von Vergleichspaste 1 erhaltenen Kontaktschichten signifikant erhöhte Schälfestigkeiten aufwiesen. Insbesondere wurden durch Verwendung von Paste 1 Kontaktschichten erzeugt, die gegenüber den durch Verwendung von Vergleichspaste 2 erzeugten Kontaktschichten über eine gleichbleibende Güte hinsichtlich der Schälfestigkeit verfügten.

### Beispiel 2:

Eine erfindungsgemäße Metallpaste, Paste 2, wurde hergestellt, indem
83 Gewichtsprozent Silberpartikel, die in der Form von Flakes vorlagen und mit Stearinsäure beschichtet waren,
12 Gewichtsprozent Exxsol™ D120, einer Mischung aus Kohlenwasserstoffen mit 14 - 18 Kohlenstoffatomen (überwiegend n-Alkane, Isoalkane und zyklische Kohlenwasserstoffe), und
5 Gewichtsprozent Silbercarbonat
zu einer homogenen Paste verrührt wurden.

Auf ein DCB *(Direct Copper Bonded*)-Substrat wurden Depots aus Paste 2 mit einer Dicke von 50 µm gedruckt, die bei einer Temperatur von 75°C für einen Zeitraum von 5 Minuten getrocknet und danach mit einem Chip mit einer Grundfläche von 10 mm² und einer Nickel-Silber-Metallisierung bestückt wurden, um eine Sandwichanordnung aus Substrat, Paste 2 und Chip zu schaffen.

Diese Sandwichanordnung wurde schließlich bei einer Temperatur von 220°C für einen Zeitraum von 15 Minuten gesintert.

Dieser Versuch wurde mehrmals unter denselben Bedingungen durchgeführt.

### Vergleichsbeispiel 2:

Eine Vergleichspaste, Vergleichspaste 2, wurde hergestellt, indem
83 Gewichtsprozent Silberpartikel, die in der Form von Flakes vorlagen und mit Stearinsäure beschichtet waren,
12 Gewichtsprozent Terpineol und
5 Gewichtsprozent Silbercarbonat
zu einer homogenen Paste verrührt wurden.

Auf ein DCB *(Direct Copper Bonded*)-Substrat wurden Depots aus Vergleichspaste 2 mit einer Dicke von 50 µm gedruckt, die bei einer Temperatur von 75°C für einen Zeitraum von 5 Minuten getrocknet und danach mit einem Chip mit einer Grundfläche von 10 mm² und einer Nickel-Silber-Metallisierung bestückt wurden, um eine Sandwichanordnung aus Substrat, Vergleichspaste 2 und Chip zu schaffen.

Diese Sandwichanordnung wurde schließlich bei einer Temperatur von 220°C für einen Zeitraum von 15 Minuten gesintert.

Dieser Versuch wurde mehrmals unter denselben Bedingungen durchgeführt.

### Vergleich der in Beispiel 2 und Vergleichsbeispiel 2 erhaltenen Kontaktschichten:

Die Scherfestigkeiten der in Beispiel 2 bzw. Vergleichsbeispiel 2 erhaltenen Kontaktschichten zwischen Substrat und Chip wurden mittels eines herkömmlichen Schertests bestimmt. Dabei stellte sich heraus, dass die durch Verwendung von Paste 2 erhaltenen Kontaktschichten gegenüber den durch Verwendung von Vergleichspaste 2 erhaltenen Kontaktschichten etwa 50 % höhere Scherfestigkeiten aufwiesen. Teilweise führten die Schertests mit den in Beispiel 2 erhaltenen Anordnungen sogar zum Chipbruch, d.h. der Chip war mit dem Substrat so stark verbunden, dass eine Entfernung nur unter Zerstörung des Chips möglich war. Insbesondere wurden durch Verwendung von Paste 2 Kontaktschichten erzeugt, die gegenüber den durch Verwendung von Vergleichspaste 2 erzeugten Kontaktschichten über eine gleichbleibende Güte hinsichtlich der Scherfestigkeit verfügten.

### Beispiel 3:

Eine erfindungsgemäße Metallpaste, Paste 3, wurde hergestellt, indem
83 Gewichtsprozent Silberpartikel, die in der Form von Flakes vorlagen und mit Stearinsäure beschichtet waren,
7 Gewichtsprozent Exxsol™ D120, einer Mischung aus Kohlenwasserstoffen mit 14 - 18 Kohlenstoffatomen (überwiegend n-Alkane, Isoalkane und zyklische Kohlenwasserstoffe),
5 Gewichtsprozent Silbercarbonat und
5 Gewichtsprozent Dicumylperoxid
zu einer homogenen Paste verrührt wurden.

Auf ein DCB (*Direct Copper Bonded*)-Substrat wurden Depots aus Paste 3 mit einer Dicke von 50 µm gedruckt, die bei einer Temperatur von 75°C für einen Zeitraum von 5 Minuten getrocknet und danach mit einem Chip mit einer Grundfläche von 10 mm² und einer Nickel-Silber-Metallisierung bestückt wurden, um eine Sandwichanordnung aus Substrat, Paste 3 und Chip zu schaffen.

Diese Sandwichanordnung wurde schließlich bei einer Temperatur von 200°C für einen Zeitraum von 15 Minuten gesintert.

Dieser Versuch wurde mehrmals unter denselben Bedingungen durchgeführt.

### Vergleichsbeispiel 3:

Eine Vergleichspaste, Vergleichspaste 3, wurde hergestellt, indem
83 Gewichtsprozent Silberpartikel, die in der Form von Flakes vorlagen und mit Stearinsäure beschichtet waren,
7 Gewichtsprozent Terpineol,
5 Gewichtsprozent Silbercarbonat und
5 Gewichtsprozent Dicumylperoxid
zu einer homogenen Paste verrührt wurden.

Auf ein DCB (*Direct Copper Bonded*)-Substrat wurden Depots aus Vergleichspaste 3 mit einer Dicke von 50 µm gedruckt, die bei einer Temperatur von 75°C für einen Zeitraum von 5 Minuten getrocknet und danach mit einem Chip mit einer Grundfläche von 10 mm² und einer Nickel-Silber-Metallisierung bestückt wurden, um eine Sandwichanordnung aus Substrat, Vergleichspaste 3 und Chip zu schaffen.

Diese Sandwichanordnung wurde schließlich bei einer Temperatur von 200°C für einen Zeitraum von 15 Minuten gesintert.

Dieser Versuch wurde mehrmals unter denselben Bedingungen durchgeführt.

### Vergleich der in Beispiel 3 und Vergleichsbeispiel 3 erhaltenen Kontaktschichten:

Die Scherfestigkeiten der in Beispiel 3 bzw. Vergleichsbeispiel 3 erhaltenen Kontaktschichten zwischen Substrat und Chip wurden mittels eines herkömmlichen Schertests bestimmt. Dabei stellte sich heraus, dass die durch Verwendung von Paste 3 erhaltenen Kontaktschichten gegenüber den durch Verwendung von Vergleichspaste 3 erhaltenen Kontaktschichten etwa 50 % höhere Scherfestigkeiten aufwiesen. Zumeist führten die Schertests mit den in Beispiel 3 erhaltenen Anordnungen sogar zum Chipbruch, d.h. der Chip war mit dem Substrat so stark verbunden, dass eine Entfernung nur unter Zerstörung des Chips möglich war. Insbesondere wurden durch Verwendung von Paste 3 Kontaktschichten erzeugt, die gegenüber den durch Verwendung von Vergleichspaste 3 erzeugten Kontaktschichten über eine gleichbleibende Güte hinsichtlich der Scherfestigkeit verfügten. Ferner war Paste 3 gegenüber Vergleichspaste 3 deutlich besser verarbeitbar.

### Beispiel 4:

Eine erfindungsgemäße Metallpaste, Paste 4, wurde hergestellt, indem
83 Gewichtsprozent Silberpartikel, die in der Form von Flakes vorlagen und mit Stearinsäure beschichtet waren,
12 Gewichtsprozent Exxsol™ D120, einer Mischung aus Kohlenwasserstoffen mit 14 - 18 Kohlenstoffatomen (überwiegend n-Alkane, Isoalkane und zyklische Kohlenwasserstoffe), und
5 Gewichtsprozent Aluminiumformiat
zu einer homogenen Paste verrührt wurden.

Auf ein DCB (*Direct Copper Bonded*)-Substrat wurden Depots aus Paste 4 mit einer Dicke von 50 µm gedruckt, die bei einer Temperatur von 75°C für einen Zeitraum von 5 Minuten getrocknet und danach mit einem Chip mit einer Grundfläche von 10 mm und einer Nickel-Silber-Metallisierung bestückt wurden, um eine Sandwichanordnung aus Substrat, Paste 4 und Chip zu schaffen.

Diese Sandwichanordnung wurde schließlich bei einer Temperatur von 220°C für einen Zeitraum von 15 Minuten gesintert.

Dieser Versuch wurde mehrmals unter denselben Bedingungen durchgeführt.

### Vergleichsbeispiel 4:

Eine Vergleichspaste, Vergleichspaste 4, wurde hergestellt, indem
83 Gewichtsprozent Silberpartikel, die in der Form von Flakes vorlagen und mit Stearinsäure beschichtet waren,
12 Gewichtsprozent Terpineol und
5 Gewichtsprozent Aluminiumformiat
zu einer homogenen Paste verrührt wurden.

Auf ein DCB (*Direct Copper Bonded*)-Substrat wurden Depots aus Vergleichspaste 4 mit einer Dicke von 50 µm gedruckt, die bei einer Temperatur von 75°C für einen Zeitraum von 5 Minuten getrocknet und danach mit einem Chip mit einer Grundfläche von 10 mm² und einer Nickel-Silber-Metallisierung bestückt wurden, um eine Sandwichanordnung aus Substrat, Vergleichspaste 4 und Chip zu schaffen.

Diese Sandwichanordnung wurde schließlich bei einer Temperatur von 220°C für einen Zeitraum von 15 Minuten gesintert.

Dieser Versuch wurde mehrmals unter denselben Bedingungen durchgeführt.

### Vergleich der in Beispiel 4 und Vergleichsbeispiel 4 erhaltenen Kontaktschichten:

Die Scherfestigkeiten der in Beispiel 4 bzw. Vergleichsbeispiel 4 erhaltenen Kontaktschichten zwischen Substrat und Chip wurden mittels eines herkömmlichen Schertests bestimmt. Dabei stellte sich heraus, dass die durch Verwendung von Paste 4 erhaltenen Kontaktschichten gegenüber den durch Verwendung von Vergleichspaste 4 erhaltenen Kontaktschichten etwa 50 bis 70 % höhere Scherfestigkeiten aufwiesen. Teilweise führten die Schertests mit den in Beispiel 4 erhaltenen Anordnungen sogar zum Chipbruch, d.h. der Chip war mit dem Substrat so stark verbunden, dass eine Entfernung nur unter Zerstörung des Chips möglich war. Insbesondere wurden durch Verwendung von Paste 4 Kontaktschichten erzeugt, die gegenüber den durch Verwendung von Vergleichspaste 4 erzeugten Kontaktschichten über eine gleichbleibende Güte hinsichtlich der Scherfestigkeit verfügten.

## Patentansprüche

1. Paste enthaltend (a) Silberpartikel, die ein Coating aufweisen, das wenigstens eine Verbindung umfasst, die aus der Gruppe ausgewählt ist, die aus Fettsäuren, Fettsäuresalzen und Fettsäureestern besteht, und (b) wenigstens eine aliphatische Kohlenwasserstoffverbindung, **dadurch gekennzeichnet, dass**
das Verhältnis der Kohlenstoffatome, die in der Hauptkette des Hauptbestandteils des Coatings enthalten sind, zu den Kohlenstoffatomen, die in der Hauptkette des Hauptbestandteils der wenigstens einen aliphatischen Kohlenwasserstoffverbindung enthalten sind, im Bereich von 0,6- 1,4 liegt.

2. Paste gemäß Anspruch 1, **dadurch gekennzeichnet, dass** die Metallpartikel als Flakes vorliegen.

3. Paste gemäß Anspruch 1 oder 2, **dadurch gekennzeichnet, dass** die wenigstens eine Coatingverbindung aus der Gruppe ausgewählt ist, die aus gesättigten Fettsäuren mit 8 - 28 Kohlenstoffatomen, Salzen von gesättigten Fettsäuren mit 8 - 28 Kohlenstoffatomen, Estern von gesättigten Fettsäuren mit 8 - 28 Kohlenstoffatomen und Mischungen davon besteht.

4. Paste gemäß einem der Ansprüche 1 - 3, **dadurch gekennzeichnet, dass** die wenigstens eine aliphatische Kohlenwasserstoffverbindung aus der Gruppe ausgewählt ist, die aus gesättigten Kohlenwasserstoffen besteht, die durch die Formeln CₙH₂ₙ₊₂, CₙH₂ₙ und CₙH₂ₙ₋₂ dargestellt sind, wobei n für eine ganze Zahl zwischen 5 und 32 steht.

5. Paste gemäß einem der Ansprüche 1 - 4, **dadurch gekennzeichnet, dass** das Verhältnis des Gewichtsanteils der Coatingverbindungen, die aus der Gruppe ausgewählt sind, die aus Fettsäuren, Fettsäuresalzen und Fettsäureestern besteht, zum Gewichtsanteil der wenigstens einen aliphatischen Kohlenwasserstoffverbindung im Bereich von 0,001 - 1,0 liegt.

6. Paste gemäß einem der Ansprüche 1 - 5, **dadurch gekennzeichnet, dass** der Anteil an Silberpartikeln, bezogen auf das Gesamtgewicht der Paste, im Bereich von 75 - 90 Gewichtsprozent liegt.

7. Paste gemäß einem der Ansprüche 1 - 6, **dadurch gekennzeichnet, dass** der Anteil an Coatingverbindungen, bezogen auf das Gesamtgewicht der Paste, im Bereich von 0,05 - 2,5 Gewichtsprozent liegt.

8. Paste gemäß einem der Ansprüche 1 - 7, **dadurch gekennzeichnet, dass** der Anteil an der wenigstens einen aliphatischen Kohlenwasserstoffverbindung, bezogen auf das Gesamtgewicht der Paste, im Bereich von 3 - 25 Gewichtsprozent liegt.

9. Paste gemäß einem der Ansprüche 1 - 8, **dadurch gekennzeichnet, dass** der Anteil an Polymeren, die ein gewichtsmittleres Molekulargewicht von weniger als 700 aufweisen, nicht mehr als 6 Gewichtsprozent, bezogen auf das Gesamtgewicht der Paste, beträgt.

10. Verwendung einer Paste gemäß einem der Ansprüche 1 - 9 zur Befestigung von einem elektronischen Bauelement auf einem Substrat.

11. Verfahren zum Befestigen eines elektronischen Bauelements auf einem Substrat, bei dem man
(i) ein elektronisches Bauelement und ein Substrat bereitstellt,
(ii) eine Sandwichanordnung schafft, die das Substrat, das elektronische Bauelement und eine dazwischen angeordnete Schicht aufweist, die eine Paste umfasst, die (a) Silberpartikel, die ein Coating aufweisen, das wenigstens eine Verbindung umfasst, die aus der Gruppe ausgewählt ist, die aus Fettsäuren, Fettsäuresalzen und Fettsäureestern besteht, und (b) wenigstens eine aliphatische Kohlenwasserstoffverbindung enthält, wobei das Verhältnis der Kohlenstoffatome, die in der Hauptkette des Hauptbestandteils des Coatings enthalten sind, zu den Kohlenstoffatomen, die in der Hauptkette des Hauptbestandteils der wenigstens einen aliphatischen Kohlenwasserstoffverbindung enthalten sind, im Bereich von 0,6 - 1,4 liegt, und
(iii) die Sandwichanordnung sintert.

## Claims

1. Paste containing (a) silver particles comprising a coating that comprises at least one compound selected from the group consisting of fatty acids, fatty acid salts, and fatty acid esters, and (b) at least one aliphatic hydrocarbon compound, **characterised in that**
the ratio of the carbon atoms present in the main chain of the main component of the coating and the carbon atoms present in the main chain of the main component of the at least one aliphatic hydrocarbon compound is in the range of 0.6 - 1.4.

2. Paste according to claim 1, **characterised in that** the metal particles are present in the form of flakes.

3. Paste according to claim 1 or 2, **characterised in that** the at least one coating compound is selected from the group consisting of saturated fatty acids having 8 - 28 carbon atoms, salts of saturated fatty acids having 8 - 28 carbon atoms, esters of saturated fatty acids having 8 - 28 carbon atoms, and mixtures thereof.

4. Paste according to any one of the claims 1 - 3, **characterised in that** the at least one aliphatic hydrocarbon compound is selected from the group consisting of saturated hydrocarbons represented by formulas, CₙH₂ₙ₊₂, CₙH₂ₙ, CₙH₂ₙ₋₂, whereby n represents an integral number between 5 and 32.

5. Paste according to any one of the claims 1 - 4, **characterised in that** the ratio of the weight fraction of the coating compounds that are selected from the group consisting of fatty acids, fatty acid salts, and fatty acid esters, and the weight fraction of the at least one aliphatic hydrocarbon compound is in the range of 0.001 - 1.0.

6. Paste according to any one of the claims 1 - 5, **characterised in that** the fraction of silver particles, relative to the total weight of the paste, is in the range of 75 - 90 % by weight.

7. Paste according to any one of the claims 1 - 6, **characterised in that** the fraction of coating compounds, relative to the total weight of the paste, is in the range of 0.05 - 2.5 % by weight.

8. Paste according to any one of the claims 1 - 7, **characterised in that** the fraction of the at least one aliphatic hydrocarbon compound, relative to the total weight of the paste, is in the range of 3 - 25 % by weight.

9. Paste according to any one of the claims 1 - 8, **characterised in that** the fraction of polymers comprising a weight-averaged molecular weight of less than 700 is no more than 6 % by weight, relative to the total weight of the paste.

10. Use of a paste according to any one of the claims 1 - 9 for attaching an electronic component on a substrate.

11. Method for attaching an electronic component on a substrate, in which one
(i) provides an electronic component and a substrate,
(ii) creates a sandwich arrangement that comprises the substrate, the electronic component, and, arranged in between these, a layer comprising a paste containing (a) silver particles comprising a coating that comprises at least one compound selected from the group consisting of fatty acids, fatty acid salts, and fatty acid esters, and (b) at least one aliphatic hydrocarbon compound, whereby the ratio of the carbon atoms present in the main chain of the main component of the coating and the carbon atoms present in the main chain of the main component of the at least one aliphatic hydrocarbon compound is in the range of 0.6 - 1.4, and
(iii) sinters the sandwich arrangement.

## Revendications

1. Particules d'argent contenant (a) de la pâte, qui présentent un revêtement qui comprend au moins une liaison sélectionnée parmi le groupe constitué des acides gras, des sels d'acides gras et des esters d'acide gras, et (b) au moins une liaison d'hydrocarbures aliphatiques, **caractérisée en ce que** le rapport des atomes de carbone contenus dans la chaîne principale de la composante principale du revêtement, aux atomes de carbone contenus dans la chaîne principale de la composante principale de l'au moins une liaison d'hydrocarbures aliphatiques, est situé dans la plage de 0,6 - 1,4.

2. Pâte selon la revendication 1, **caractérisée en ce que** les particules métalliques sont présentes sous forme de paillettes.

3. Pâte selon la revendication 1 ou 2, **caractérisée en ce que** l'au moins une liaison de revêtement est sélectionnée parmi le groupe composé des acides gras saturés avec 8 - 28 atomes de carbone, des sels d'acides gras saturés avec 8 - 28 atomes de carbone, des esters d'acides gras saturés avec 8 - 28 atomes de carbone et des mélanges de ceux-ci.

4. Pâte selon l'une des revendications 1 à 3, **caractérisé en ce que** l'au moins une liaison d'hydrocarbures aliphatiques est sélectionnée parmi le groupe composé d'hydrocarbures saturés qui sont représentés par les formules CₙH₂ₙ₊₂, CₙH₂ₙ et CₙH₂ₙ₋₂, sachant que n est un nombre entier entre 5 et 32.

5. Pâte selon l'une des revendications 1 à 4, **caractérisé en ce que** le rapport de la teneur en poids des liaisons de revêtement qui sont sélectionnées parmi le groupe composé des acides gras, des sels d'acides gras et des esters d'acide gras, à la teneur en poids de l'au moins une liaison d'hydrocarbures aliphatiques, est situé dans la plage de 0,001 - 1.

6. Pâte selon l'une des revendications 1 à 5, **caractérisé en ce que** la teneur en particules d'argent, rapporté au poids total de la pâte, est située dans la plage de 75 - 90 pourcents en poids.

7. Pâte selon l'une des revendications 1 à 6, **caractérisé en ce que** la teneur en liaisons de revêtement, rapporté au poids total de la pâte, est située dans la plage de 0,05 - 2,5 pourcents en poids.

8. Pâte selon l'une des revendications 1 à 7, **caractérisé en ce que** la teneur en l'au moins une liaison d'hydrocarbures aliphatiques, rapporté au poids total de la pâte, est située dans la plage de 3 - 25 pourcents en poids.

9. Pâte selon l'une des revendications 1 à 8, **caractérisé en ce que** la teneur en polymères, qui présentent un poids moléculaire de poids moyen inférieur à 700, ne fait pas plus de 6 pourcents en poids, rapporté au poids total de la pâte.

10. Emploi d'une pâte selon l'une des revendications 1 - 9 pour fixer un composant électronique sur un substrat.

11. Procédé de fixation d'un composant électronique sur un substrat, dans lequel
(i) on fournit un composant électronique et un substrat,
(ii) on crée un agencement en sandwich qui présente le substrat, le composant électronique et une couche disposée entre eux, qui comprend une pâte, qui contient (a) des particules d'argent qui présentent un revêtement qui comprend au moins une liaison, qui est sélectionnée parmi le groupe constitué des acides gras, des sels d'acides gras et des esters d'acide gras, et (b) au moins une liaison d'hydrocarbures aliphatiques, sachant que le rapport des atomes de carbone contenus dans la chaîne principale de la composante principale du revêtement, aux atomes de carbone contenus dans la chaîne principale de la composante principale de l'au moins une liaison d'hydrocarbures aliphatiques, est situé dans la plage de 0,6 - 1,4, et
(iii) on fritte l'agencement en sandwich.
